# FASCICULE DE BREVET EUROPEEN

(11) **EP 0 517 599 B1**
(45) Date de publication et mention de la délivrance du brevet: **11.05.1994**
(21) Numéro de dépôt: 92401541.5
(22) Date de dépôt: 04.06.1992
(51) Int. Cl.: H03G 3/20, H03G 3/30

(54) **Circuit amplificateur large bande à contrôle automatique de gain et de tension de décalage**
Breitbandverstärkerstufe mit automatischer Verstärkungsregelung und Offsetregelung
Broadband amplifier with automatic control of the gain and the offset

(30) Priorité: 07.06.1991 FR 9106939
(43) Date de publication de la demande: 09.12.1992
(73) Titulaire: ALCATEL N.V., NL-1077 XX Amsterdam (NL); ALCATEL CIT, 75008 Paris (FR)
(72) Inventeur: Albouy, Pierre, F-22300 Lannion (FR); Cochennec, Guy, F-22560 Pleumeur Bodou (FR)
(74) Mandataire: Sciaux, Edmond

(56) Documents cités:
- FR-A- 2 642 918
- PATENT ABSTRACTS OF JAPAN vol. 9, no. 43 (E-298)22 Février 1985
- ELECTRONICS AND COMMUNICATIONS IN JAPAN. vol. 67-C, no. 4, 1984, NEW YORK US pages 85 - 92; T. KAMOTO E.A.: 'Bipolar monolithic very-wideband amplifier.'

## Description

L'invention concerne un circuit amplificateur large bande à contrôle automatique de gain et de tension de décalage, ce circuit étant notamment du type capable d'amplifier un signal de plusieurs centaines de Mbit/s, par exemple 600 Mbit/s.

Le signal est délivré par exemple par un préamplificateur associé en entrée à une photodiode.

On connaît, par l'article "Bipolar Monolithic Very-Wideband Amplifier" de T. Kamato et autres, paru dans la revue Electronics and Communications in Japan, Vol. 67-C, N° 4, 1984, pages 85 à 92, un amplificateur égaliseur à la large bande comprenant un amplificateur d'entrée (buffer) un amplificateur à contrôle automatique de gain, un amplificateur, un circuit de contrôle de décalage (offset control) agissant sur l'entrée de l'amplificateur d'entrée et un circuit de contrôle automatique de gain agissant sur l'amplificateur à contrôle automatique de gain. Cet amplificateur égaliseur présente l'inconvénient d'avoir un contrôle de gain dépendant du contrôle de décalage.

On connaît, par l'article "Wideband and High-Gain Negative-Feedback AGC Amplifier for hight-speed Ligthwave digital Transmission Systems" de K. Yamashita et autres, paru dans la revue Electronics Letters du 9 Mai 1985, Vol. 21, N° 10,pages 419 et 420, un amplificateur à contrôle automatique de gain qui présente l'inconvénient d'avoir une pointe de gain aux hautes fréquences (de l'ordre de 0,5 GHz) lorsqu'il fonctionne en gain minimum, d'où des risques d'oscillations; en outre la correction de cette pointe de gain est difficile du fait qu'elle varie selon le gain.

On connaît, de JP-A-59 183 516, un amplificateur différentiel comprenant un circuit d'élimination de la tension de décalage.

L'invention a pour but de rendre le contrôle automatique de gain et le contrôle de décalage indépendants l'un de l'autre.

Un autre but de l'invention est de supprimer les risques d'oscillations lorsque le circuit amplificateur fonctionne en haute fréquence au gain minimum.

Il a par ailleurs déjà été proposé par la demanderesse dans son brevet FR-2.642.918 un circuit amplificateur large bande comprenant principalement deux amplificateurs à contrôle de gain associés à un post-amplificateur ayant une sortie directe et une sorte inversée auxquelles sont respectivement reliés deux détecteurs de crête. Un troisième amplificateur dont la sortie est reliée à une entrée de commande de gain de chacun des deux premiers amplificateurs à contrôle de gain, à une entrée à un potentiel fixe et une autre entrée reliée respectivement par deux résistances aux deux détecteurs de crête précités.

La demanderesse propose, par la présente invention, un circuit amplificateur large bande d'un type nouveau et qui possède une boucle de contre-réaction pour le contrôle du gain et une autre boucle pour le contrôle et l'annulation en sortie d'une éventuelle tension de décalage (tension "d'offset").

La présente invention a donc pour objet un circuit amplificateur large bande à contrôle automatique de gain et de tension de décalage comportant une chaîne principale amplificatrice, une boucle de contre-réaction pour le contrôle du gain et une boucle de contre-réaction pour le contrôle et l'annulation en sortie d'une éventuelle tension de décalage, ladite chaîne principale amplificatrice comportant un bloc amplificateur à contrôle de gain ayant une entrée de contrôle de gain reliée à la boucle de contre-réaction pour le contrôle de gain;
caractérisé en ce que le bloc amplificateur à contrôle de gain est précédé dans la chaîne principale par un bloc symétriseur-additionneur à gain fixe ayant une première entrée constituant l'entrée du circuit amplificateur et une seconde entrée reliée à la boucle de contre-réaction pour le contrôle et l'annulation en sortie d'une éventuelle tension de décalage.

De façon particulièrement avantageuse, les boucles de contre-réaction sont réalisées en mode différentiel. Le bloc symétriseur-additionneur comporte deux parties, une première partie ayant: une entrée constituant la première entrée du bloc symétriseur-additionneur, un étage à transconductance pour adapter l'impédance de l'entrée du circuit amplificateur et amplifier avec un gain fixe un signal appliqué à cette entrée, et une sortie différentielle pour mettre ce signal en mode différentiel; une seconde partie comportant un additionneur ayant: une entrée différentielle reliée à la sortie de la première partie, une entrée différentielle constituant la seconde entrée du bloc symétriseur-additionneur , et une sortie différentielle.

Selon une autre caractéristique, la chaîne principale amplificatrice comporte en outre un bloc de sortie recevant un signal différentiel délivré par le bloc amplificateur à contrôle de gain et ayant une sortie différentielle constituant la sortie du circuit amplificateur et fournissant un signal différentiel dont la tension de mode commun est asservie pour être égale à une tension fixée. De préférence, le bloc de sortie délivre des signaux différentiels de deux fois 500 mV centrés sur une tension de -1,32 v. De préférence encore, les boucles de contre-réaction comprennent des amplificateurs opérationnels à entrée et sortie différentielles. Un amplificateur opérationnel d'une boucle de contre-réaction peut être un amplificateur opérationnel à sortie différentielle à tension de mode commun contrôlée en sortie.

La description qui suit d'un mode de réalisation de l'invention est purement illustrative et non limitative. Elle doit être lue en regard des dessins annexés, sur lesquels:

La Figure 1 est un schéma d'un circuit amplificateur conforme à l'invention.

La Figure 2 est une représentation plus détaillée d'une portion du circuit amplificateur de la Figure 1.

La Figure 3 est un schéma d'un sous-circuit de sortie du circuit amplificateur de la Figure 1.

La Figure 4 est une représentation d'un mode de réalisation particulier d'une unité du circuit amplificateur de la Figure 1.

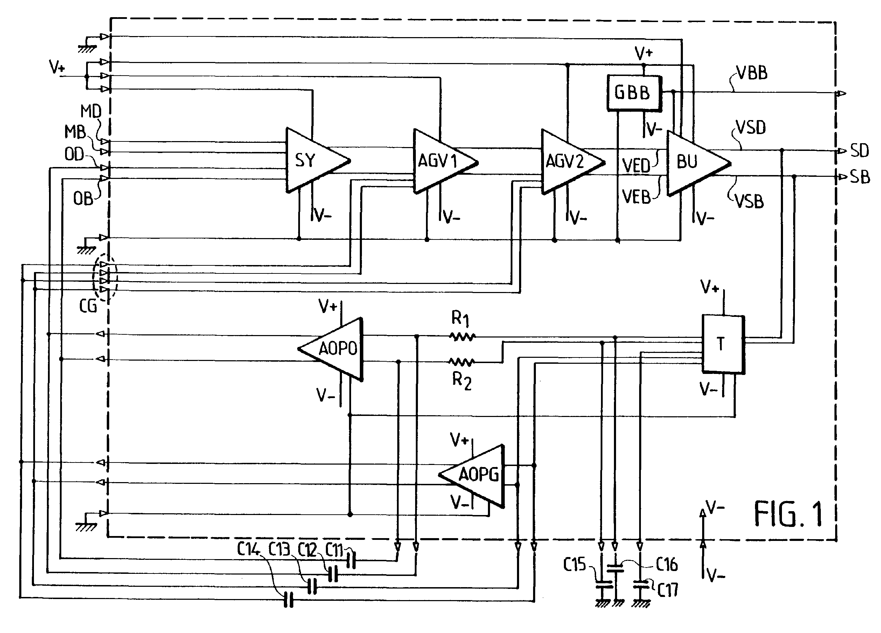

On voit sur la Figure 1 que le circuit amplificateur conforme à l'invention comprend une chaîne principale amplificatrice réalisée par un symétriseur-additionneur SY à gain fixe, suivi de deux amplificateurs à gain variable AGV1 et AGV2 ainsi que d'un bloc de sortie (buffer) BU, en cascade.

Les boucles de réaction gain et "offset" sont quant à elles réalisées par l'intermédiaire chacune d'un amplificateur opérationnel référencé respectivement par AOPG et AOPO, et un étage commun T appelé composant de transfert différentiel. Un générateur GBB fournit une tension fixe VBB utilisée par le bloc de sortie BU pour contrôler la tension de mode commun en sortie du circuit amplificateur.

Le circuit amplificateur reçoit un signal à amplifier sur une entrée asymétrique MD, MB. Il fournit un signal amplifié VSD, VSB, sur une sortie différentielle SD, SB. Les composants entourés par des pointillés sur la figure sont réalisés en un seul circuit intégré. Les autres composants sont extérieurs à ce circuit intégré. Tous les composants sont alimentés par une tension V+ et une tension V- respectivement positive et négative par rapport à un potentiel de référence.

La tension différentielle VSP, VSB en sortie de l'amplificateur de sortie BU est envoyée sur le composant de transfert différentiel T. Le composant T est associé à trois condensateurs C15, C16, C17 pour déterminer de manière classique: d'une part la valeur de crête du signal différentiel VSD, VSB; et d'autre part une éventuelle tension de décalage. Une première sortie différentielle du composant T fournit un signal de correction de décalage et est reliée: à une entrée différentielle de l'amplificateur AOPO pour deux résistances R1, R2; et au potentiel de référence par les condensateurs C15 et C16. Une deuxième sortie différentielle du composant T fournit un signal de contrôle de gain et est reliée: à une entrée différentielle de l'amplificateur AOPG par des liaisons directes. Une sortie différentielle de l'amplificateur AOPO constitue une sortie de boucle de contrôle et d'annulation d'un éventuel décalage. Cette sortie fournit une tension différentielle de correction de tension de décalage, à une entrée différentielle OD, OB du symétriseur-additionneur SY, et est rebouclée à l'entrée différentielle de l'amplificateur AOPO par deux condensateurs C11, C12 respectivement.

Une sortie différentielle de l'amplificateur AOPG constitue une sortie de la boucle de contrôle de gain. Cette sortie est reliée à une entrée différentielle CG commune aux amplificateurs AVG1 et AVG2 et permettant de commander leur gains par une tension. Cette sortie est, par ailleurs rebouclée à l'entrée différentielle de l'amplificateur AOPG par deux condensateurs C13, C14 respectivement.

On emploie le mode différentiel pour chacune des deux boucles de contre-réaction, ce qui permet une meilleure immunité aux perturbations extérieures et donc globalement un bruit inférieur en sortie.

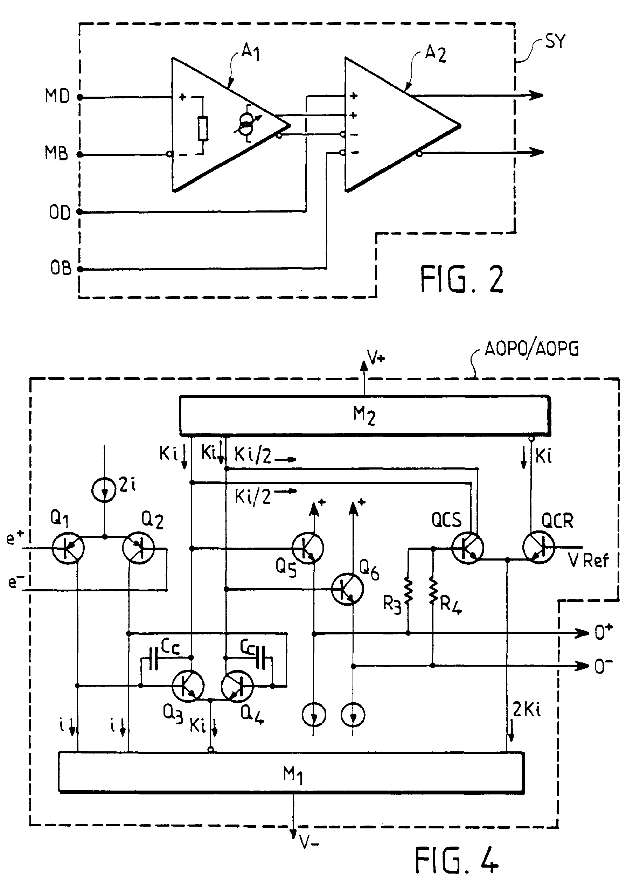

On a représenté plus particulièrement sur la Figure 2 le bloc SY. Celui-ci se décompose en un premier amplificateur A1 qui symétrise le signal à amplifier en le mettant en mode différentiel, et qui adapte l'impédance d'entrée et amplifie le signal via un étage de transconductance, et en un deuxième amplificateur A2 qui réalise une addition du signal différentiel de sortie de l'amplificateur A1 avec la tension différentielle de correction de tension de décalage, puis une amplification à gain fixe, pour l'attaque du bloc suivant. L'amplificateur A2 possède une sortie différentielle reliée à une entrée différentielle de l'amplificateur AGV1.

Une telle structure présente de nombreux avantages. En particulier l'impédance d'entrée est fixe et n'est pas altérée par les modifications de gain, comme c'était le cas avec les circuits amplificateurs connus jusqu'à présent, dans lesquels l'amplificateur recevant la tension d'entrée recevait également la boucle de contre-réaction de gain.

Egalement, l'addition de la tension de décalage s'y fait en différentiel et sur un point de plus haute impédance, puisqu'elle n'est plus faite directement en entrée. La symétrisation (passage d'un mode asymétrique en entrée à un mode différentiel en sortie) s'y fait sur deux étages et diminue l'injection de mode commun en entrée du bloc à gain variable AGV1, AGV2. Egalement encore, le gain fixe avant passage par les amplificateurs à gain variable AGV1 et AGV2 améliore le rapport signal-bruit S/B.

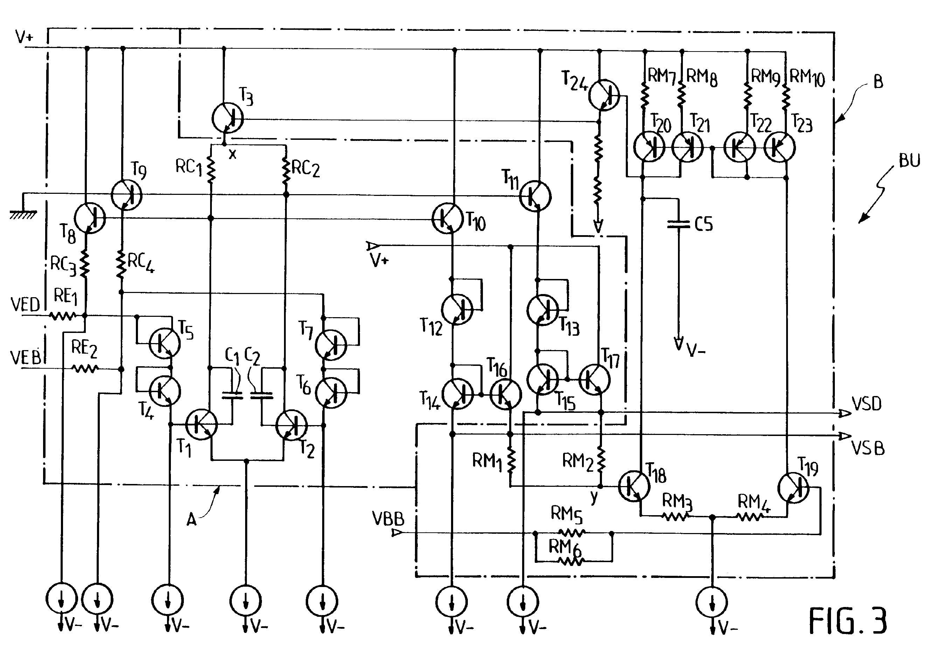

Le bloc de sortie BU a été représenté plus particulièrement sur la Figure 3. Ce bloc doit délivrer des signaux différentiels de deux fois 500 mV centrés sur la tension VBB (- 1,32 V). L'amplitude est contrôlée par la boucle de contre-réaction agissant sur le gain, mais une structure particulière est nécessaire pour contrôler la tension de mode commun en sortie. Des structures classiques permettant un contrôle de ce type sont déjà connues. Les variations des tensions base-collecteur des transistors y sont compensées par les variations d'autres tensions base-émetteur d'autres transistors, ceci néanmoins toujours au détriment des performances en bande passante. L'invention propose pour sa part une structure qui permet de pallier cet inconvénient.

Cette structure a été plus particulièrement représentée sur la Figure 3 et comprend en particulier une partie A asservie par une partie B. La partie A amplifie le signal différentiel VED, VEB appliqué à l'entrée du bloc de sortie BU, et délivre le signal différentiel VSD, VSB: en sortie du bloc BU. Le signal différentiel VSD, VSB a une tension de mode commun commandable par une tension appliquée à une entrée X de la partie A. Cette entrée X est reliée à une sortie de la partie B. Cette dernière réalise un asservissement fournissant au point X une tension telle que la tension de mode commun en sortie du bloc BU reste toujours égale à la tension fixée VBB.

Plus précisément, cette partie A comprend principalement deux transistors T1, T2, montés en paire différentielle, les bases de ces transistors T1, T2 étant reliées à leur collecteur par l'intermédiaire de capacités de compensation C1, C2. Les bornes communes, d'une part de la capacité C1 et du collecteur du transistor T1 et d'autre part, de la capacité C2 et du collecteur du transistor T2, sont reliées respectivement par l'intermédiaire des résistances RC1 et RC2 à l'émetteur d'un transistor T3 appartenant à la partie B. Le point X est la borne commune à l'émetteur du transistor T3 et aux résistances RC1 et RC2. La base du transistor T1 est également reliée à deux transistors T4, T5 montés en diodes en série, et recevant, par l'intermédiaire d'une résistance d'entrée RE1, l'une des tensions d'entrée VED du bloc de sortie. Symétriquement, le transistor T2 est associé à deux transistors T6 et T7 montés en diode en série recevant, par l'intermédiaire d une résistance RE2, la deuxième entrée différentielle VEB du bloc de sortie BU. Le point commun de la résistance RE1 et des transistors montés en diode T4, T5, et le point commun de la résistance RE2 et des transistors T6, T7 sont reliés respectivement aux émetteurs de deux transistors T8, T9 par deux résistances de contre-réaction RC3 et RC4. Les transistors T8 et T9 sont montés en collecteur commun. Leurs bases sont respectivement reliées aux bases de deux transistors T10, T11 également montés en collecteur commun. Les bases de T8, T10 et T9, T11 sont respectivement reliées au collecteur de T1 et T2. Les émetteurs de ces deux transistors T10, T11 sont respectivement reliés aux collecteurs de transistors montés en diode T12, T13 eux-mêmes en série avec respectivement un des transistors T14, T15 également montés en diode dont les bases et collecteurs sont reliés respectivement à la base d'un transistor T16, T17. Les émetteurs de ces transistors T16 et T17 délivrent les tensions de sortie différentielle VSD et VSB du bloc de sortie BU. Leurs collecteurs sont reliés ensemble à une tension d'alimentation V+.

La partie B est reliée quant à elle à cette partie A, notamment par l'intermédiaire de deux résistances RM1 et RM2 reliées aux émetteurs des transistors T16 et T17 ayant une borne commune en un point Y reliée à la base d'un transistor T18. Le point Y fournit la moyenne de VSD et VSB c'est-à-dire la tension de mode commun du signal différentiel VSD, VSB. Cette tension est comparée à la tension de consigne VBB au moyen des transistors T18 et T19 montés en amplificateur différentiel. L'émetteur de ce transistor T18 est relié par une résistance RM3, d'une part à un fil de polarisation et d'autre part à une autre résistance RM4 reliée à l'émetteur d'un transistor T19. Ce transistor T19 reçoit VBB sur sa base par deux résistances RM5 et RM6 montées en parallèles. Le collecteur du transistor T18 est relié, d'une part à une capacité de découplage C5, et d'autre part au collecteur de deux transistors PNP, T20 et T21 dont les émetteurs sont reliés, par l'intermédiaire des résistances RM7 et RM8 à la tension commune V+. Egalement, le collecteur du transistor T19 est relié au collecteur de deux transistors T22 et T23 montés en diodes et dont les émetteurs sont également reliés par l'intermédiaire de résistances RM9 et RM10 à la tension commune V+. Les bases des transistors T20 à T23 sont toutes reliées les unes aux autres. La borne commune des collecteurs des transistors T20 et T21 est reliée à la base d'un transistor T24 en collecteur commun et dont l'émetteur est relié à la base du transistor T3, dont l'émetteur est relié au circuit A.

La tension de mode commun de VSD, VSB du circuit A est fonction du potentiel au point X. Ce potentiel peut évoluer sous l'action dudit circuit B qui est un asservissement contrôlant la tension en Y et la maintenant égale à la tension VBB. Cette tension fixée VBB est donnée par le générateur GBB de réalisation classique, à "Band-Gap".

On a représenté sur la Figure 4, un amplificateur opérationnel à entrée et sortie différentielles pouvant être utilisé pour réaliser l'amplificateur AOPO ou l'amplificateur AOPG. C'est un amplificateur opérationnel à sortie différentielle et à tension de mode commun contrôlée en sortie. Il comprend principalement un miroir de courant M1 recevant deux entrées de courant i provenant des collecteurs de deux transistors Q1 et Q2 PNP, montés en paire différentielle et polarisés par une source de courant 2i. Entre les collecteurs de ces deux transistors Q1 et Q2 est montée une paire différentielle de transistors Q3, Q4, NPN dont les émetteurs sont reliés par un fil commun au miroir de courant M1 qui reçoit un courant Ki. Le collecteur et la base de chacun de ces deux transistors Q3, Q4, sont reliés par une capacité de compensation C_{c}. Les collecteurs de ces deux transistors Q3 et Q4, sont également reliés tous deux à des sorties d'un miroir M2. Chacune de ces deux sorties envoie un courant Ki vers le transistor Q3, Q4, auquel elle est associée. Ce courant Ki se scinde en deux courants Ki/2, l'un allant vers les transistors Q3 ou Q4, l'autre vers le collecteur d'un transistor à deux sorties QCS, qui forme, avec un transistor QCR simple, une paire différentielle alimentée par une source de courant 2Ki, le collecteur du transistor QCR est relié au miroir M2, sa base recevant une tension de référence Vref. Entre chacun des collecteurs des transistors Q3, Q4, et le noeud qui renvoie une partie du courant Ki en sortie du miroir M2 vers le différentiel QCS, QCR sont branchées respectivement les bases des transistors Q5, Q6 à collecteur commun et dont les émetteurs renvoient sur une tension de sortie respectivement 0+ et 0-. Des résistances R3 et R4 relient respectivement la base du transistor QCS à 0+ et à 0-.

Ainsi, la source de courant 2i pilote tous les courants de l'amplificateur. L'équilibre de mode commun des courants de mode commun du premier étage est assuré par le miroir M1 attaqué par le deuxième étage différentiel. L'équilibre de mode commun en sortie est assuré par le différentiel QCS-QCR. QCS possède deux sorties (deux transistors en parallèle) qui agissent directement sur les collecteurs de transistors Q3 et Q4, afin d'assurer la stabilité de la boucle de contre-réaction mode commun sans que d'autres capacités de compensation que les capacités C_{c} ne soient nécessaires (les capacités C_{c} sont nécessaires pour le mode différentiel).

Les signes de référence insérés après les caractéristiques techniques mentionnées dans les revendications, ont pour seul but de faciliter la compréhension de ces dernières, et n'en limitent aucunement la portée.

## Revendications

1. Circuit amplificateur large bande à contrôle automatique de gain et de tension de décalage comportant une chaîne principale amplificatrice (SY, AVG1, AVG2, BU), une boucle (T, AOPG) de contre-réaction pour le contrôle du gain et une boucle (T, AOPO) de contre-réaction pour le contrôle et l'annulation en sortie d'une éventuelle tension de décalage, ladite chaîne principale amplificatrice comportant un bloc amplificateur à contrôle de gain (AGV1, AGV2), ayant une entrée de contrôle de gain (CG) reliée à la boucle (T, AOPG) de contre-réaction pour le contrôle de gain;
caractérisé en ce que le bloc amplificateur à contrôle de gain (AGV1, AGV2) est précédé dans la chaîne principale par un bloc symétriseur-additionneur (SY) à gain fixe ayant une première entrée (MD, MB) constituant l'entrée du circuit amplificateur et une seconde entrée (OD, OB) reliée à la boucle (T, AOPO) de contre-réaction pour le contrôle et l'annulation en sortie d'une éventuelle tension de décalage.

2. Circuit amplificateur selon la revendication 1, caractérisé en ce que les boucles de contre-réaction sont réalisées en mode différentiel.

3. Circuit amplificateur selon la revendication 2, caractérisé en ce que le bloc symétriseur additionneur (SY) comporte deux parties (A1, A2), une première partie (A1) ayant: une entrée constituant la première entrée (MD, MB) du bloc soustracteur (SY), un étage à transconductance pour adapter l'impédance de l'entrée (MD, MB) du circuit amplificateur et amplifier avec un gain fixe un signal appliqué à cette entrée, et une sortie différentielle pour mettre ce signal en mode différentiel; une seconde partie (A2) comportant un additionneur ayant: une entrée différentielle reliée à la sortie de la première partie (A1), une entrée différentielle constituant la seconde entrée (OD, OB) du bloc symétriseur-additionneur (SY), et une sortie différentielle fournissant un signal à envoyer sur le bloc amplificateur à contrôle de gain (AGV1, AGV2).

4. Circuit amplificateur selon l'une des revendications 2 ou 3, caractérisé en ce que la chaîne principale amplificatrice comporte en outre un bloc de sortie (BU) recevant un signal différentiel (VED, VEB) délivré par le bloc amplificateur à contrôle de gain (AVG1, AVG2) et ayant une sortie différentielle constituant la sortie du circuit amplificateur et fournissant un signal différentiel (VSD, VSB) dont la tension de mode commun (Y) est asservie pour être égale à une tension fixée (VBB).

5. Circuit amplificateur selon la revendication 4, caractérisé en ce que le bloc de sortie (BU) délivre des signaux différentiels de deux fois 500 mV centrés sur une tension de moins -1,32 v.

6. Circuit amplificateur selon la revendication 2, caractérisé en ce que les boucles de contre-réaction comprennent des amplificateurs (AOPG, AOPO) opérationnels à entrée et sortie différentielles.

7. Circuit amplificateur selon la revendication 6, caractérisé en ce qu'au moins un amplificateur opérationnel (AOPO, AOPG) d'une boucle de contre-réaction est un amplificateur opérationnel à sortie différentielle à tension de mode commun contrôlée en sortie.

## Patentansprüche

1. Breitbandverstärkerschaltung mit automatischer Verstärkungs- und Offsetspannungsregelung, mit einer Hauptverstärkungskette (SY, AVG1, AVG2, BU), einer Rückkopplungsschleife (T, AOPG) für die Verstärkungsregelung und einer Rückkopplungsschleife (T, AOPO) zur Regelung und Eliminierung einer eventuellen Offsetspannung am Ausgang, wobei die Hauptverstärkerkette einen Verstärkerblock mit Verstärkungsregelung (AGV1, AGV2) enthält, deren Verstärkungsregelungseingang (CG) an die Rückkopplungsschleife (T, AOPG) für die Verstärkungsregelung angeschlossen ist, dadurch gekennzeichnet, daß in der Hauptkette dem Verstärkerblock mit Verstärkungsregelung (AGV1, AGV2) ein Symmetrier-Addierblock (SY) mit festem Verstärkungsgrad vorausgeht, dessen erster Eingang (MD, MB) den Eingang der Verstärkerschaltung bildet und dessen zweiter Eingang (OD, OB) an die Rückkopplungsschleife zur Regelung und Eliminierung einer eventuellen Offsetspannung am Ausgang angeschlossen ist.

2. Verstärkerschaltung nach Anspruch 1, dadurch gekennzeichnet, daß die Rückkopplungsschleifen im differentiellen Modus gebildet sind.

3. Verstärkerschaltung nach Anspruch 2, dadurch gekennzeichnet, daß der Symmetrier-Addierblock (SY) zwei Teile (A1, A2) besitzt, von denen ein erster Teil (A1) einen den ersten Eingang (MD, MB) des Subtrahierblocks (SY) bildenden Eingang, eine Transkonduktanzstufe zur Impedanzanpassung des Eingangs (MD, MB) der Verstärkerschaltung und zur Verstärkung eines an diesen Eingang angelegten Signals mit festem Verstärkungsgrad und einen differentiellen Ausgang aufweist, um dieses Signal in den Differentialmodus zu bringen, während ein zweiter Teil (A2) einen Addierer enthält, der einen an den Ausgang des ersten Teils (A1) angeschlossenen differentiellen Eingang, einen den zweiten Eingang (OD, OB) des Symmetrier-Addierkreises (SY) bildenden differentiellen Eingang und einen differentiellen Ausgang besitzt, der ein Signal an den Verstärkerblock mit Verstärkungsregelung (AGV1, AGV2) liefert.

4. Verstärkerschaltung nach einem der Ansprüche 2 oder 3, dadurch gekennzeichnet, daß die Hauptverstärkerkette außerdem einen Ausgangsblock (BU) enthält, der ein differentielles Signal (VED, VEB) vom Verstärkerblock mit Verstärkungsregelung (AGV1, AGV2) empfängt und einen differentiellen Ausgang besitzt, der den Ausgang der Verstärkerschaltung bildet und ein differentielles Signal (VSD, VSB) liefert, dessen Gleichtaktspannung (Y) geregelt ist, um einer festen Spannung (VBB) gleich zu sein.

5. Verstärkerschaltung nach Anspruch 4, dadurch gekennzeichnet, daß der Ausgangsblock (BU) differentielle Signale von zweimal 500 mV liefert, die auf eine Spannung von -1,32 V zentriert sind.

6. Verstärkerschaltung nach Anspruch 2, dadurch gekennzeichnet, daß die Rückkopplungsschleifen Operationsverstärker (AOPG, AOPO) mit differentiellem Eingang und Ausgang enthalten.

7. Verstärkerschaltung nach Anspruch 6, dadurch gekennzeichnet, daß mindestens ein Operationsverstärker (AOPO) einer Rückkopplungsschleife ein Operationsverstärker mit differentiellem Ausgang und ausgangsseitig geregelter Gleichtaktspannung ist.

## Claims

1. A wideband amplifier circuit having automatic offset voltage and gain control, the circuit comprising a main amplifier chain (SY, AVG1, AVG2, BU), a negative feedback loop (T, AOPG) for controlling gain, and a negative feedback loop (T, AOPO) for controlling and cancelling any possible offset voltage at its output, said main amplifier chain including a gain control amplifier block (AGV1, AGV2) having a gain control input (CG) connected to the gain control negative feedback loop (T, AOPG); the circuit being characterized in that the gain control amplifier block (AGV1, AGV2) is preceded in the main chain by a symmetrizer-adder block (SY) of fixed gain having a first input (MD, MB) constituting the input of the amplifier circuit and a second input (OD, OB) connected to the negative feedback loop (T, AOPO) for controlling and cancelling any possible offset voltage at the output.

2. An amplifier circuit according to claim 1, characterized in that the negative feedback loops are implemented in differential mode.

3. An amplifier according to claim 2, characterized in that the symmetrizer-adder block (SY) comprises two portions (A1, A2): a first portion (A1) having an input constituting the first input (MD, MB) of the symmetrizer-adder block (SY), a transconductance stage for matching the input impedance (MD, MB) of the amplifier circuit and for amplifying a signal applied to said input with fixed gain, and a differential output for putting said signal into differential mode; and a second portion (A2) comprising an adder having a differential input connected to the output of the first portion (A1), a differential input constituting the second input (OD, OB) of the symmetrizer-adder block (SY), and a differential output providing a signal to be applied to the gain control amplifier block (AGV1, AGV2).

4. An amplifier circuit according to claim 2 or 3, characterized in that the main amplifier chain further includes an output block (BU) receiving a differential signal (VED, VEB) delivered by the gain control amplifier block (AVG1, AVG2) and having a differential output constituting the output of the amplifier circuit and delivering a differential signal (VSD, VSB) whose common mode voltage (Y) is servo-controlled to be equal to a fixed voltage (VBB).

5. An amplifier circuit according to claim 4, characterized in that the output block (BU) delivers differential signals of twice 500 mV centered on a voltage of -1.32 V.

6. AN amplifier circuit according to claim 2, characterized in that the negative feedback loops include operational amplifiers (AOPG, AOPO) having differential inputs and outputs.

7. An amplifier circuit according to claim 6, characterized in that at least one of the operational amplifiers (AOPO, AOPG) in a negative feedback loop is an operational amplifier having a differential output with output control common mode voltage.
